# EUROPÄISCHE PATENTSCHRIFT

(11) **EP 0 965 062 B1**
(45) Veröffentlichungstag und Bekanntmachung des Hinweises auf die Patenterteilung: **27.06.2001**
(21) Anmeldenummer: 98916845.5
(22) Anmeldetag: 03.03.1998
(51) Int. Cl.: G02B 6/42

(54) **HERSTELLUNGSVERFAHREN FÜR EIN ELEKTROOPTISCHES MODUL**
METHOD FOR PRODUCING AN ELECTRO-OPTICAL MODULE
PROCEDE DE PRODUCTION D'UN MODULE ELECTRO-OPTIQUE

(30) Priorität: 07.03.1997 DE 19711138
(43) Veröffentlichungstag der Anmeldung: 22.12.1999
(73) Patentinhaber: Infineon Technologies AG, 81669 München (DE)
(72) Erfinder: KROPP, Jörg-Reinhardt, D-12355 Berlin (DE)
(74) Vertreter: Zedlitz, Peter, Dipl.-Inf.
(86) Internationale Anmeldenummer: DE9800631
(87) Internationale Veröffentlichungsnummer: WO9840775

(56) Entgegenhaltungen:
- EP-A- 0 053 482
- CHUN C K Y ET AL: "AN INEXPENSIVE PASSIVE METHOD OF ALIGNING FIBERS TO LASER OR PHOTODETECTOR ARRAYS" MOTOROLA TECHNICAL DEVELOPMENTS, Bd. 29, November 1996, Seiten 152-155, XP000691918

## Beschreibung

Die Erfindung liegt auf dem Gebiet der Herstellung elektrooptischer Baugruppen oder Module, die üblicherweise eine auch als Steckbucht bezeichnete Aufnahme zum Anschluß und zur optischen Ankopplung geeigneter Kopplungspartner, z. B. optischer Leitungen, aufweisen. Als Kopplungspartner sind auch andere optische oder elektrooptische Elemente - z. B. zu Zwecken galvanischer Trennungen auch ein weiteres elektrooptisches Modul - denkbar. Derartige Module weisen zur Wandlung elektrischer in optische bzw. zur Wandlung optischer in elektrische Signale elektrooptische Wandler auf, die einen im Rahmen der vorliegenden Erfindung auch als optisch aktive Zone bezeichneten lichtabstrahlenden (Sender) oder lichtsensitiven (Empfänger) Bereich haben. Für einen hohen Kopplungswirkungsgrad bei der Einspeisung oder Ausspeisung optischer Signale in Wellenleiter ist neben der elektrooptischen Transformation der Signale auch eine präzise Ankopplung der signalableitenden und/oder signalzuführenden Lichtwellenleiter (Kopplungspartner) erforderlich. Als Sender werden in der optischen Übertragungstechnik z. B. lichtemittierende Dioden (LED) oder horizontalstrahlende Laserdioden eingesetzt. Diese haben bauartbedingt häufig eine große numerische Apertur, die für eine optische Kopplung mit hohem Wirkungsgrad die Verwendung von Linsen erfordert.

Die Erfindung betrifft ein Herstellungsverfahren für ein elektrooptisches Modul, bei dem ein elektrooptischer Wandler in vorbestimmter Position auf einem Träger angeordnet wird und bei dem der Träger mit dem Wandler zumindest teilweise in einen Formkörper aus einem formbaren Material eingebettet wird, wobei der Formkörper zumindest eine der Kopplung mit einem Kopplungspartner dienende Funktionsfläche aufweist.

Ein derartiges Herstellungsverfahren ist aus der EP 0 053 482 A2 bekannt. Bei dem bekannten Herstellungsverfahren wird zunächst aus einem Blech (beispielsweise einer Kupferfolie) ein Träger (lead frame) in gewünschter Form ausgestanzt und goldbeschichtet. Anschließend wird der Wandler (im Falle eines Senders beispielsweise eine Laserdiode oder im Falle eines Empfängers eine Fotodiode) auf dem Träger montiert und zur elektrischen Ansteuerung oder Signalverbindung über Bonddrähte und Leitpaste kontaktiert. Anschließend wird der Träger zusammen mit dem Wandler und ggf. weiteren Ansteuerschaltungen in Halbschalen eingebracht, die eine Gußform mit gewünschter Kontur bilden. In die Gußform wird geeignetes transparentes wärmeaushärtbares Harz eingebracht und unter Temperatur und Druck ein den Wandler einbettender Formkörper erzeugt. Der Formkörper weist zumindest eine der Kopplung mit einem Kopplungspartner dienende Funktionsfläche mit vorgegebener Kontur auf. Die Funktionsfläche kann beispielsweise die konvexe Fläche einer der Strahlformung zwischen dem Wandler und einem anzukoppelnden Lichtwellenleiter dienenden Linse sein. Die Funktionsfläche kann aber auch oder zusätzlich als Anschlagfläche oder Ausrichtfläche für den Kopplungspartner (z. B. einen Lichtwellenleiterstecker) ausgebildet sein. Der Formkörper wird anschließend in ein Gehäuse mit mechanischen Verriegelungselementen für den Kopplungspartner eingebracht.

Das bekannte Herstellungsverfahren umfaßt zwei besonders kritische Fertigungsschritte - nämlich die Positionierung des Wandlers auf dem Träger und die Positionierung des Trägers in der Gußform -, von deren Präzision unmittelbar der mit dem elektrooptischen Modul erreichbare Einkopplungs- bzw. Auskopplungswirkungsgrad abhängt. Diesbezüglich gibt die EP 0 053 482 A2 keinerlei weiterführende Lehre.

Die Aufgabe der Erfindung besteht daher in der Bereitstellung eines Herstellungsverfahrens für ein elektrooptisches Modul, das in bezug auf die Position des elektrooptischen Wandlers bzw. dessen optisch aktiver Zone in zuverlässig reproduzierbarer Weise eine äußerst präzise Anordnung oder Ausbildung der Funktionsfläche gewährleistet.

Diese Aufgabe wird bei einem Herstellungsverfahren der eingangs genannten Art erfindungsgemäß dadurch gelöst, daß der Träger mit mindestens einem Positionierelement versehen wird, daß der Träger mittels des Positionierelements exakt in einer Bestückungseinrichtung positioniert wird, in der der Wandler auf dem Träger in zu dem Positionierelement präziser relativer Lage angeordnet und fixiert wird, und daß der Träger nachfolgend mittels des Positionierelements exakt in einer Gußform positioniert und unter Ausbildung des Formkörpers und der Funktionsfläche mit dem formbaren Material umgeben wird.

Ein wesentlicher Vorteil des erfindungsgemäßen Herstellungsverfahrens besteht darin, daß unter Verwendung einfacher Teile und Herstellungstechniken weiterhin ein kostengünstiger Aufbau bei äußerst präziser relativer Lage des elektrooptischen Wandlers in Bezug auf die Funktionsfläche gesichert ist. Da sämtliche diesbezüglich kritischen Fertigungsschritte jeweils auf dieselbe(n) Referenzmarke(n) - nämlich das oder mehrere Positionierelement(e) - bezogen sind, ist unabhängig von der Genauigkeit beispielsweise der Außenkonturherstellung des Trägers stets eine äußerst präzise relative Ausrichtung von Wandler und Funktionsfläche gegeben. Wie bereits erwähnt, kann die Funktionsfläche beispielsweise eine Linsenfläche oder eine Anschlagfläche sein; die Art der Funktionsfläche ist aber nicht darauf beschränkt, sondern kann z. B. auch als Spiegelfläche ausgebildet sein. Das Positionierelement kann vorteilhafterweise als Ausnehmung oder Erhebung ausgebildet sein. Grundsätzlich sind alle für eine reproduzierbare lagegenaue Positionierung des Trägers geeigneten konstruktiven und/oder geometrischen Elemente im Rahmen der vorliegenden Erfindung einsetzbar. Besonders bevorzugt werden mehrere Positionierelemente auf, in oder an dem Träger vorgesehen.

Eine in dieser Hinsicht besonders bevorzugte Ausgestaltung des erfindungsgemäßen Verfahrens sieht vor, daß der Träger mit zwei kreisrunden Ausnehmungen als Positionierelemente versehen wird.

Die Erfindung wird nachfolgend anhand einer Zeichnung weiter dargestellt; es zeigen zur Erläuterung der einzelnen Verfahrensschritte des erfindungsgemäßen Verfahrens:
Figuren 1 und 2 Schnitte eines ersten Moduls,
Figur 3 eine erste Modulvariante und
Figur 4 eine weitere Modulvariante.

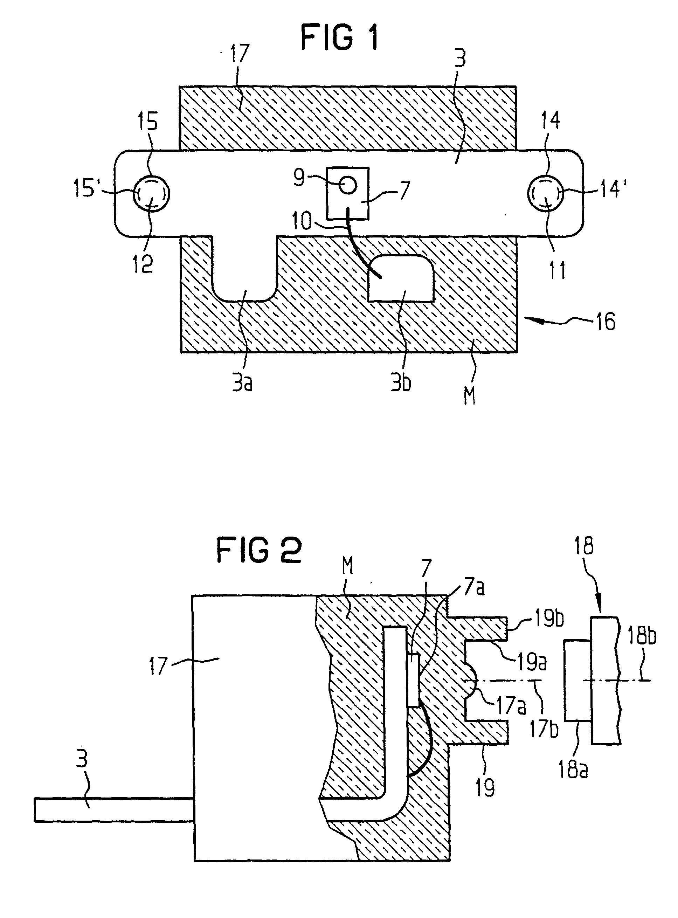

Figur 1 zeigt im Querschnitt ein Modul mit einem Träger (lead frame) 3, der mehrere nach außen führende Anschlußkontakte 3a, 3b zur externen elektrischen Kontaktierung des Moduls 1 aufweist. Auf dem Träger 3 ist ein elektrooptischer Wandler 7 angeordnet und mittels Leitpaste oder Lötung 9 elektrisch leitend mit dem Träger verbunden. Über einen Bonddraht 10 ist ein weiterer Anschluß des Wandlers 7 mit dem Außenkontakt 3b elektrisch leitend verbunden.

Um den Wandler 7 exakt auf dem Träger 3 zu positionieren, wird nach dem erfindungsgemäßen Verfahren der Träger in eine nicht näher dargestellte Bestückungseinrichtung eingelegt. Zur in bezug auf die Bestückungseinrichtung präzisen Positionierung des Trägers 3 dienen trägereigene Ausnehmungen in Form zweier kreisrunder Bohrungen 11, 12 an den jeweils seitlichen Enden des Trägers 3. Die Ausnehmungen 11, 12 werden zur Positionierung - wie in Figur 1 aus Gründen der übersichtlicheren Darstellung nur andeutungsweise dargestellt - von Positionierzapfen 14, 15 der Bestückungseinrichtung formschlüssig durchdrungen. Damit ist eine äußerst präzise Ablage des Wandlers 7 in bezug auf den Träger 3 ermöglicht, wobei anschließend der Wandler über die Lötung 9 verbunden wird. Alternativ kann der Wandler auch beispielsweise durch Klebung fixiert werden. Durch handelsübliche, hochpräzise Ablageeinrichtungen ist eine Positionsgenauigkeit von weniger als 10 µm relativ zu den trägerseitigen Ausnehmungen 11, 12 erreichbar. Nach dem anschließenden, in Figur 1 bereits dargestellten Drahtbonden wird der Träger in eine nur angedeutete Vergußform 16 eingelegt, die in entsprechend präziser Anordnung ebenfalls Positionierzapfen 14', 15' aufweist, so daß der Träger 3 erneut äußerst präzise - diesmal im Hinblick auf die Gußform 16 - positioniert wird. Bei dem anschließenden Verguß mit formbarem Material M entsteht der in Figur 1 bereits gezeigte Formkörper 17, in den der Wandler 7 eingebettet ist. Durch den Formkörper 17 treten die Kontakte 3a, 3b zur Kontaktierung nach außen.

Ein entscheidender Aspekt des erfindungsgemäßen Herstellungsverfahrens besteht also darin, daß für die beiden Verfahrensschritte sowohl der Wandlerpositionierung als auch des anschließenden zumindest teilweisen Einbettens des Trägers 3 mit dem Wandler 7 in den durch Spritzguß gebildeten Formkörper 17 jeweils dieselben oder zumindest zueinander hochpräzise ausgebildete Positionierelemente 11, 12 verwendet werden. Dadurch wird sichergestellt, daß die Lage des Wandlers 7 mit höchster Genauigkeit zu der Vergußform 16 und damit zu von der Vergußform erzeugten Funktionsflächen ausgerichtet ist.

Wie die Ansicht des Moduls im teilweisen Längsschnitt in Figur 2 zeigt, sind gemäß der Gußform spezielle Außenkonturen des Formkörpers 17 gebildet worden. Im einzelnen ist eine Linse 17a ausgebildet, die der optisch aktiven Zone 7a des Wandlers 7 in hochpräziser Ausrichtung gegenüberliegt. Dadurch wird - im Falle eines optischen Senders - von dem Wandler 7 emittierte Strahlung exakt auf der optischen Achse 17b der Linse 17d ausgesendet und damit nahezu fehlerfrei in gewünschter Weise zur Einkopplung an einen - in Form eines von einem Steckerstift 18a aufgenommenen Endes eines Lichtwellenleiters 18b - angedeuteten Kopplungspartner 18 geformt. Weiterhin weist der Formkörper 17 eine Steckbucht 19 auf, deren Innenfläche 19a zur Ausrichtung des Kopplungspartners (z. B. des Steckerstiftes 18a) und/oder einer anzuschließenden Koppelvorrichtung ebenfalls höchstpräzise in bezug auf die optisch aktive Zone 7a ausgebildet ist. Die Stirnseite 19b der Bucht 19 kann als bezüglich der Linse 17a und der Zone 7a hochpräzise ausgebildete und beabstandete Anschlagfläche dienen.

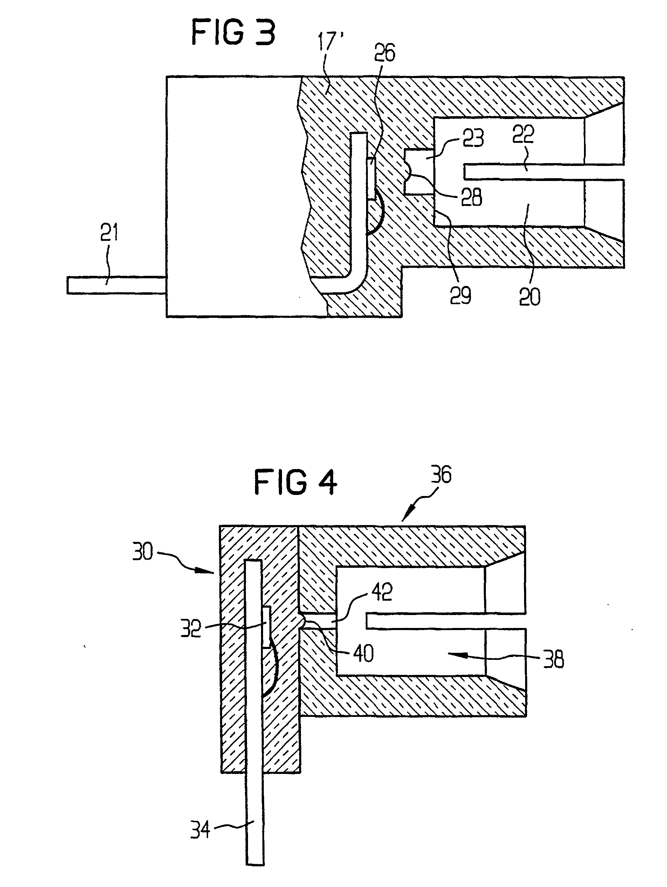

In Figur 3 ist eine Variante des in den Figuren 1 und 2 dargestellten Moduls gezeigt, die sich im wesentlichen durch eine einstückig mit dem Formkörper 17' ausgebildete Aufnahmehülse 20 für einen Kopplungspartner in Form eines an sich bekannten Steckerstiftes mit einem in zentraler Bohrung gehaltenen Lichtwellenleiterende unterscheidet. Die Hülse 20 weist einen Schlitz 22 zur federnden Aufnahme des Steckerstiftes auf. Innenseitig ist in präziser Ausrichtung zu dem Wandler 26 und der wie vorstehend beschrieben gebildeten Linse 28 eine Anschlagstirnfläche 29 ausgebildet. Der Wandler 26 ist in vorbeschriebener Weise über elektrische Anschlußkontakte (z. B. 21) zur elektrischen Ansteuerung bzw. (bei einem Empfänger) zum Abgreifen der elektrischen Signale versehen.

Bei der in Figur 4 gezeigten Variante umfaßt das Modul einen Modulhauptkörper 30 mit dem Wandler 32 und Anschlußkontakten 34 sowie ein als Aufnahme ausgestaltetes separat fertigbares und montierbares Modulteil 36. Das Modulteil 36 weist in der Figur 3 entsprechender Weise eine Aufnahmehülse 38 für einen Lichtwellenleitersteckerstift auf. Durch eine Bohrung 42 ist sowohl ein Lichtdurchtritt zwischen Hülsenbereich und Wandler als auch eine präzise Ausrichtung auf die wie vorstehend detailliert erläutert höchst präzise in bezug auf die optisch aktive Fläche des Wandlers 32 ausgebildete Funktionsfläche in Form einer Linse 40 gewährleistet. Der Formschluß der Linse 40 mit der Durchgangsbohrung 42 bewirkt eine hochpräzise Ausrichtung des Kopplungspartners in bezug auf den Wandler 32. Hier wirkt die Funktionsfläche 40 also in Doppelfunktion sowohl als Linse zur Strahlformung als auch zur Ausrichtung des zweiten Teils 36.

Das den Formkörper 17, 17' bzw. 30 bildende Material ist zumindest im Bereich der optisch aktiven Zone des jeweiligen Wandlers für die Lichtwellenlänge des Wandlers bzw. des eingesetzten Systems durchlässig. Als Positionierelemente 11, 12 (Figuren 1 und 2) sind neben den gezeigten kreisrunden Ausnehmungen auch anders geformte Ausnehmungen, Erhebungen, Vertiefungen oder Markierungen denkbar, solange die Positionierelemente die ihnen obliegende Funktion der zweifachen exakten Positionierung sowohl während des Bestückungsvorganges mit dem Wandler als auch während des anschließenden Vergußvorgangs zur Bildung des Formkörpers erfüllen.

Das erfindungsgemäße Verfahren schafft ein Modul zur optischen Signalübertragung, das einen hohen Kopplungswirkungsgrad gewährleistet. Je nach Anschlußlichtwellenleiter bzw. Kopplungspartner und Wandlertyp sind unterschiedliche Modulaufbauten realisierbar, so daß die Funktionsflächen (beispielsweise Anschlag- oder Referenzflächen, Linsenflächen, Spiegelflächen) bedarfsgemäß gestaltet werden können und dabei stets eine hohe Lagegenauigkeit in bezug auf den Wandler haben. Das Herstellungsverfahren erlaubt einen sehr kostengünstigen und an Einzelteilen sehr armen Aufbau, wobei der Wandler bei vollständiger Einbettung in das Material des Formkörpers gegen äußere Umwelteinflüsse zuverlässig geschützt ist.

## Patentansprüche

1. Herstellungsverfahren für ein elekrooptisches Modul,
- bei dem ein elekrooptischer Wandler (7) in vorbestimmter Position auf einem Träger (3) angeordnet wird und
- bei dem der Träger (3) mit dem Wandler (7) zumindest teilweise in einen Formkörper (17) aus einem formbaren Material (M) eingebettet wird,
- wobei der Formkörper (17) zumindest eine der Kopplung mit einem Kopplungspartner (18) dienende Funktionsfläche (17a, 19b) aufweist,
**dadurch gekennzeichnet**,
- daß der Träger (3) mit mindestens einem Positionierelement (11, 12) versehen wird,
- daß der Träger (3) mittels des Positionierelements (11, 12) exakt in einer Bestückungseinrichtung positioniert wird, in der der Wandler (7) auf dem Träger (3) in zu dem Positionierelement (11, 12) präziser relativer Lage angeordnet und fixiert wird, und
- daß der Träger (3) nachfolgend mittels des Positionierelements (11, 12) exakt in einer Gußform (16) positioniert und unter Ausbildung des Formkörpers (17) und der Funktionsfläche (17a, 19b) mit dem formbaren Material (M) umgeben wird.

2. Verfahren nach Anspruch 1,
**dadurch gekennzeichnet,**
- daß der Träger (3) mit zwei kreisrunden Ausnehmungen als Positionierelemente (11, 12) versehen wird.

## Claims

1. Method for producing an electro-optical module,
- in which an electro-optical transducer (7) is arranged in a predetermined position on a substrate (3), and
- in which the substrate (3) is embedded with the transducer (7) at least partially in a moulded part (17) made from a mouldable material (M),
- the moulded part (17) having at least one functional surface (17a, 19b) serving for a coupling to a coupling partner (18),
characterized
- in that the substrate (3) is provided with at least one positioning element (11, 12),
- in that the substrate (3) is positioned by means of the positioning element (11, 12) exactly in an insertion device in which the transducer (7) on the substrate (3) is arranged and fixed in a precise position relative to the positioning element (11, 12), and
- in that the substrate (3) is subsequently positioned exactly in a casting mould (16) by means of the positioning element (11, 12), and is surrounded by the mouldable material (M) with the formation of the moulded part (17) and the functional surface (17a, 19b).

2. Method according to Claim 1, characterized
- in that the substrate (3) is provided with two circular cut-outs as positioning elements (11, 12).

## Revendications

1. Procédé de fabrication d'un module électro-optique,
- dans lequel un convertisseur (7) électro-optique est monté en une position prédéterminée sur un support (3) et
- dans lequel le support (3) comportant le convertisseur (7) est enrobé au moins partiellement dans un corps (17) de moulage en un matériau (M) déformable,
- le corps (17) comportant au moins une surface (17a, 19b) fonctionnelle servant au couplage avec un partenaire (18) de couplage,
caractérisé
- en ce que le support (3) est muni d'au moins un élément (11, 12) de mise en position,
- en ce que le support (3) est mis en position au moyen de l'élément (11, 12) de mise en position de manière exacte dans un dispositif d'implantation dans lequel le convertisseur (7) est monté et immobilisé sur le support (3) en position relative précise par rapport à l'élément (11, 12) de mise en position, et
- en ce que le support (3) est mis en position ensuite au moyen de l'élément (11, 12) de mise en position de manière exacte dans un moule (16) de coulée et entouré du matériau (M) déformable avec formation du corps (17) de moulage et de la surface (17a, 19b) fonctionnelle.

2. Procédé suivant la revendication 1, caractérisé
- en ce que le support (3) est muni de deux évidements circulaires ronds comme éléments (11, 12) de mise en position.
